# EUROPEAN PATENT SPECIFICATION

(11) **EP 3 332 472 B1**
(45) Date of publication and mention of the grant of the patent: **29.07.2020**
(21) Application number: 16756853.4
(22) Date of filing: 05.08.2016
(51) Int. Cl.: H02M 3/156

(54) **ADJUSTING PEAK INDUCTOR CURRENT TO LIMIT SUPPLY INPUT CURRENT**
EINSTELLUNG DES SPITZENINDUKTORSTROMS ZUR BEGRENZUNG DES VERSORGUNGSEINGANGSSTROMS
RÉGLAGE DE COURANT MAXIMAL DE BOBINE D'INDUCTANCE POUR LIMITER UN COURANT D'ENTRÉE D'ALIMENTATION

(30) Priority: 07.08.2015 US 201562202295 P
(43) Date of publication of application: 13.06.2018
(73) Proprietor: Cirrus Logic International Semiconductor Ltd., Quartermile Edinburgh EH3 9EG (GB)
(72) Inventor: MAY, Jeffrey Allen, Dripping Springs, Texas 78620 (US); KING, Eric J., Austin, Texas 78704 (US); HE, Ku, Austin, Texas 78751 (US); VADNERKAR, Sarang, Austin, Texas 78701 (US); PAZHAYAVEETIL, Ullas, Cedar Park, Texas 78613 (US); BURK, Theodore M., Cedar Park, Texas 78613 (US)
(74) Representative: Haseltine Lake Kempner LLP
(86) International application number: PCT/US2016/045818
(87) International publication number: WO 2017/027393

(56) References cited:
- US-A1- 2014 117 960
- US-A1- 2014 247 029
- US-B1- 6 215 288

## Description

### FIELD OF DISCLOSURE

The present disclosure relates in general to circuits concerning or relating to dynamically limiting the peak current consumption of a switching direct-current to direct-current (DC-DC) boost converter based on power supply conditions, triggering various user configurable or dynamic thresholds which result in a managed change of the switching converter's peak current limiting with the purpose of dynamically restricting peak power supply consumption from the boost converter's supply. Applications may include, but are not limited to, cell phones, media players, tablets, laptops, other portable battery powered devices, and other devices, that use audio amplifiers, boosted audio amplifiers, or other amplifier devices that can produce a large dynamic load on the battery, causing either a system overload or large voltage supply drop on the battery. The actual loading and demands on the supply can vary based on the end-user selected content, such as voice or audio playback.

### BACKGROUND

Portable devices are becoming more common in every aspect of our lives and affect how we interact with our music. For example, many consumers listen to their music from portable audio players, such as MP3 players or their cellular phones. These portable devices become easier and more enjoyable to use when the portable devices shrink in size while offering the same capabilities and when the portable devices can last longer from a single battery charge. To support longer lasting devices, the operating voltage of the components inside the portable device is often reduced to reduce power consumption by these components. However, a reduction in operating voltage affects the sound output of the portable device, because the volume level of an audio signal output to a speaker is proportional to the output voltage. Thus, boost converters have been used to increase operating voltages for select components within a portable device that benefit from higher voltages, such as the audio amplifier that needs high voltages to generate high volumes.

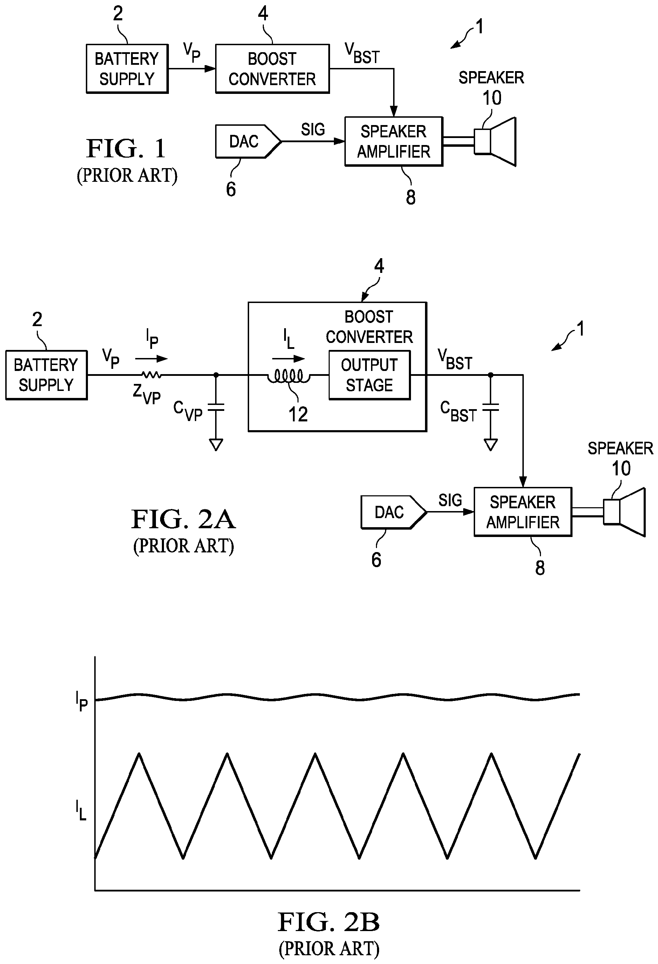

FIGURE 1 illustrates an example audio amplifier 1 with a boost converter, as is known in the relevant art. Audio amplifier 1 may include a battery supply 2 that provides a voltage, V_{P}, to a boost converter 4. Boost converter 4 may increase the voltage V_{P} to a boost voltage, V_{BST}. A speaker amplifier 8 may receive the boost voltage V_{BST}, and an analog audio signal, SIG, from a digital-to-analog converter (DAC) 6. Speaker amplifier 8 may increase the low power signal of audio signal SIG with power received from the boost converter 4 to generate a signal to drive a speaker 10. Boost voltage V_{BST} may be higher than supply voltage V_{P} which may allow speaker amplifier 8 to provide louder volume ranges through speaker 10 than possible with only supply voltage V_{P}.

In battery powered devices, the amount of peak available power can vary based on the operational state of the battery. If the battery or voltage power supply is in a low charge state, its ability to provide current or maintain an output voltage is typically reduced from when it is operating in a full-charge state. On systems having audio amplifiers supplied by boost converters, the boost converter's output power to the audio amplifier may determine how much power can be delivered to the load and therefore how much acoustic energy (loudness) can be produced from the speaker load.

In the example, boosted amplifier 1 shown in FIGURE 1, when the peak inductor current through boost converter 4 is limited, both the maximum input power consumption of the system and the maximum output power that can be delivered to amplifier 8 and through the load (e.g., speaker 10) are, in turn, also limited.

In general, batteries can supply a finite amount of output current. In complex portable devices, such as cellular phones, media players, tablets, laptops, etc., this current budget is shared among multiple end product subsystems (e.g., applications, processor, LCD screen, cellular radio, etc.). In order to meet the market's demands for higher audio loudness from these portable devices, the boosted audio amplifier can consume large peaks of energy from the battery supply. The existence of a boost converter allows more power to be driven from the amplifier to the load but at the expense of more power consumption. This tradeoff means that the boosted amplifier device must be able to limit and manage its maximum power consumption from the battery supply appropriately in order to operate properly within the limits of the battery's capabilities and co-exist with other end product subsystems, while not producing a low voltage "brownout" event on the portable device.

Boost converters in these types of systems often have peak inductor current limiters in order to restrict current consumption through an inductor and a switch (e.g., a field-effect transistor or "FET") of the boost converter. The inductor's peak current limit may be leveraged to a certain extent to restrict input power to the boost converter. However, such limiting is typically performed in a very static manner, and the system does not take into account changes in battery supply voltage or inductance. Thus, the relationship between peak inductor current and battery supply current consumption may vary, reducing the ability of accurately managing battery supply current consumption through a peak inductor current limit.

For example, if the boosted amplifier's peak inductor current limit is statically configured to limit power consumption for purposes of preventing the boosted amplifier from overloading the battery when in a low voltage or weakened state of operation, it cannot fully utilize the additional available power from the battery when it is more fully charged. Configuring a peak inductor current limit in this manner produces an overly conservative power consumption limitation for most of the battery's operational life in order to provide protection for a worst case operating condition. The conservative configuration restricts power delivery from the boost converter to the amplifier and to the load (speaker), translating into a restricting output power to the speaker.

Conversely, if the boosted amplifier's peak inductor current is configured more aggressively to take advantage of the power available when the battery is fully charged, the system then risks overloading the supply once the battery has discharged. This more aggressive configuration of the inductor current can cause a low supply voltage event that can cause the device to self-reset or "brownout." This self-reset or "brownout" event is both displeasing to the user of the portable device and can be problematic for the device producer.

In order to protect against a worst case condition and still allow for utilization of the additional battery supply power when available, the power consumption limiting must dynamically adapt to the battery supply and operational conditions of the boosted amplifier.

FIGURE 2A illustrates example audio amplifier 1 of FIGURE 1 and various parasitic or intrinsic impedances associated with components of example audio amplifier 1, as is known in the relevant art. In operation, as shown in FIGURE 2B, most of the switching peak-to-peak ripple inductor current I_{L} through an inductor 12 of boost converter 4 may be filtered by a local capacitance C_{VP} of battery supply 2 and any series impedance Z_{VP} in battery supply 2 itself or in a connection between battery supply 2 and an input of boost converter 4. A current I_{P} as seen by battery supply 2 and supplied to audio amplifier 1 may typically be much lower in frequency than inductor current I_{L}.

A number of methods and systems for monitoring, managing conditions, and/or improving amplification of a boost converter generally exist.

As a first example, U.S. Patent Publication No. 20150030183 filed on February 18, 2014, entitled "Boost Converter Voltage Controlled Based on Audio Signal," and assigned to Cirrus Logic, Inc., which is incorporated by reference herein, discloses a way for "audio amplification to be improved by controlling an audio amplifier based on the audio signal being amplified. For instance, when the audio signal level increases or decreases, a boost voltage provided to an audio amplifier by a boost converter may also be increased or decreased. As another instance, when the audio signal level decreases below a certain level, the audio amplifier may be switched from amplifying the audio signal with a boost converter input to amplifying the audio signal with a low voltage input. Control of the audio amplifier may be implemented in a digital boost converter controller coupled to the boost converter and/or the audio amplifier."

As a second example, U.S. Patent Publication No. 20150032396 filed on February 18, 2014, entitled "Boost Converter Controller with Inductance Value Determination," and assigned to Cirrus Logic, Inc., which is incorporated by reference herein, discloses "a controller of a boost converter [that] may be configured to dynamically adjust conditions within the boost converter by monitoring conditions in the boost converter. For instance, the controller may determine a current inductance value for an inductor of the boost converter by monitoring a current through the inductor. When the inductance value of the inductor is known, a slope compensation value may be used in determining a transition time between charging the inductor of the boost converter and discharging the inductor."

As a third example, U.S. Serial No. 14/182,939 filed on February 18, 2014, entitled "Determination of Inductor Current During Reverse Current in a Boost Converter," and assigned to Cirrus Logic, Inc., which is incorporated by reference herein, discloses that "during operation of a boost converter, conditions may exist that result in a reverse current through the boost converter, such as when a load drop from the boost converter occurs. During the reverse current period, inductance value determinations made during a forward current period may be used to estimate a magnitude of the reverse current, and this estimate is used by a controller to control the boost converter and return the boost converter to normal operation. The controller may control the boost converter by changing a ratio of charging and discharging time for an inductor of the boost converter, decreasing a bandwidth of the boost converter, and/or increasing a resistance of the boost converter."

As a fourth example, U.S. Pat. No. 9,391517 filed on February 18, 2014, entitled "Controller for Adjusting a Switching Frequency in a Boost Converter," and assigned to Cirrus Logic, Inc., which is incorporated by reference herein, discloses that "thermal levels in an inductor of a boost converter may be managed by controlling an average current through the inductor. For example, a switching frequency of the boost converter between charging and discharging the inductor may be increased or decreased. Increasing or decreasing the switching frequency results in a corresponding decrease or increase in the switching period for the boost converter. The controller may adjust the switching frequency to control the average current level while maintaining a peak-to-peak current level in the inductor by monitoring the inductance of the inductor and the peak current level in the inductor."

As a fifth example, U.S. Serial No. 14/183,096 filed on February 18, 2014, entitled "Controller for Imposing Current Limits on a Boost Converter for Managing Thermal Loads," and assigned to Cirrus Logic, Inc., which is incorporated by reference herein, discloses "thermal levels in an inductor of a boost converter being managed by implementing peak current limits for the boost converter. For example, an inductor may be allowed to conduct a certain peak current limit for a certain period of time before the current is reduced by a controller to a low current limit. The controller may hold the low current limit in place for a certain period of time, after which the current through the inductor is allowed to again exceed the low current limit. However, if the high current limit is again exceeded or sustained for a certain period of time, the low current limit may be again imposed by the controller. In this fifth example, the digitally regulated peak current mode controlled boost converter with peak current hard-limit and soft-limit leverages a fixed hard-limit, with a dynamic soft limit specifically for purposes of protecting an inductor from failure mechanisms, such as thermal overheating." Further, the US patent application US 2014/0247029-A1, filed at Feb. 26, 2014, discloses a boost converter for converting between an input voltage and an output voltage. This boost converter includes an inductor connected to the input voltage, a switching arrangement for controlling the switching of the inductor current to an output load at the output voltage and a controller for controlling the switching arrangement to provide duty cycle control.

### SUMMARY

In accordance with the teachings of the present disclosure, one or more disadvantages and problems associated with existing approaches to controlling current consumption in a power converter may be reduced or eliminated.

In accordance with embodiments of the present disclosure, a method may include monitoring an input power supply voltage of a power supply, monitoring an inductance of an inductor of a boost converter comprising the inductor, monitoring one or more other characteristics of the boost converter, and calculating a target peak inductor current based on the input power supply voltage, the inductance, the one or more other characteristics of the boost converter, and a target average current of the inductor during a switching cycle of the boost converter.

In accordance with these and other embodiments of the present disclosure, an apparatus may include a boost converter having a power supply input for receiving an input power supply voltage of a power supply, an inductor, and an output for generating an output voltage greater than the input power supply voltage and a controller configured to monitor the input power supply voltage, monitor the inductance of the inductor, monitor one or more other characteristics of the boost converter, and calculate a target peak inductor current based on the input power supply voltage, the inductance, the one or more other characteristics of the boost converter, and a target average current of the inductor during a switching cycle of the boost converter.

In accordance with these and other embodiments of the present disclosure, a method may include monitoring an input power supply voltage of a power supply, monitoring an inductance of an inductor of a boost converter comprising the inductor, monitoring one or more other characteristics of the boost converter, and calculating an average current of the inductor during a switching cycle of the boost converter based on the input power supply voltage, the inductance, the one or more other characteristics of the boost converter, and a peak inductor current of the inductor.

In accordance with these and other embodiments of the present disclosure, an apparatus may include a boost converter having a power supply input for receiving an input power supply voltage of a power supply, an inductor, and an output for generating an output voltage greater than the input power supply voltage, and a controller configured to monitor the input power supply voltage, monitor the inductance of the inductor, monitor one or more other characteristics of the boost converter, and calculate an average current of the inductor during a switching cycle of the boost converter based on the input power supply voltage, the inductance, the one or more other characteristics of the boost converter, and a peak inductor current of the inductor.

Technical advantages of the present disclosure may be readily apparent to one of ordinary skill in the art from the figures, description and claims included herein. The objects and advantages of the embodiments will be realized and achieved at least by the elements, features, and combinations particularly pointed out in the claims.

It is to be understood that both the foregoing general description and the following detailed description are examples and explanatory and are not restrictive of the claims set forth in this disclosure.

### BRIEF DESCRIPTION OF THE DRAWINGS

A more complete understanding of the example, present embodiments and certain advantages thereof may be acquired by referring to the following description taken in conjunction with the accompanying drawings, in which like reference numbers indicate like features, and wherein:
FIGURE 1 illustrates an example audio amplifier with a boost converter, as is known in the relevant art;
FIGURE 2A illustrates the example audio amplifier of FIGURE 1 with various parasitic or intrinsic impedances associated with components of the example audio amplifier, as is known in the relevant art;
FIGURE 2B illustrates an example graph of a power supply current I_{P} and an inductor current I_{L} versus time within the audio amplifier of FIGURE 1, as is known in the relevant art;
FIGURE 3 illustrates a block diagram of an example boost converter system 8, in accordance with embodiments of the present disclosure;
FIGURE 4 illustrates a block diagram of an example dynamic peak current control 1 for use in boost converter system 8, in accordance with embodiments of the present disclosure;
FIGURE 5 is a circuit diagram of a model of an example battery which may be used as a power supply, in accordance with embodiments of the present disclosure;
FIGURE 6 depicts a graph of an average input current versus a supply voltage to illustrate an example of how a multi-threshold current-limiting approach with programmable response rates could respond with a varying supply voltage, in accordance with embodiments of the present disclosure;
FIGURE 7 depicts a graph of a peak inductor current limit versus a supply voltage to illustrate how a user may configure various response rates in order to customize a soft-limiting response based on system power to a system comprising a boost converter, in accordance with embodiments of the present disclosure;
FIGURE 8 depicts a graph of a peak inductor current limit and a supply voltage Vp over time to illustrate how a single-threshold linear response could track a supply voltage transient waveform in order to reduce input current consumption as supply voltage decreases, in accordance with embodiments of the present disclosure;
FIGURE 9 depicts a graph of a peak inductor current limit and supply voltage over time to illustrate an example implementation of a peak inductor current limiting time-based response, in accordance with embodiments of the present disclosure;
FIGURE 10 depicts a graph of a peak inductor current limit and a supply voltage over time to illustrate an example implementation in which a peak current soft-limit is continually reduced until the supply voltage has returned above an initial triggering threshold of a peak inductor current limiting time-based response, in accordance with embodiments of the present disclosure; and
FIGURE 11 depicts a graph of a peak inductor current limit and a supply voltage over time to illustrate an example implementation utilizing a multi-threshold response wherein as the supply voltage decreases below each threshold, a different response rate is applied for each threshold, in accordance with embodiments of the present disclosure.

### DETAILED DESCRIPTION

In accordance with embodiments of the present disclosure, systems and methods may be provided for dynamically adapting a peak inductor current of a boosted amplifier in order to manage supply power current consumption. By dynamically adapting the peak inductor current of a boosted amplifier, a supply current provided to the boosted amplifier from a power supply (e.g., battery supply) may be managed, thus allowing the boosted amplifier to adapt to maximize delivery power to the load when the system allows for it while still appropriately limiting input power consumption when the power supply is less capable of supplying power to a system comprising the boosted amplifier. It may also allow for the leveraging of a peak current control mechanism that already commonly exists within traditional boost converters. The dynamic peak current control disclosed herein may leverage a concept of applying a hard limit to peak inductor current and a dynamically variable soft limit lesser than the hard limit in order to adapt peak inductor current in accordance with system parameters and operating conditions. However, in the present disclosure, such dynamic peak current control may not serve the purpose of protecting the inductor, but rather may be used in order to restrict maximum input power consumption of the boosted amplifier based on system level operating conditions. Thus, a peak inductor current hard limit may be increased to utilize additional power from the power supply when available, and the peak inductor current soft limit may dynamically adapt based on system conditions in order to prevent power supply overload as a battery discharges and weakens, preventing an overload, power supply voltage droop, or brownout condition.

The dynamic peak current control system allows the user to limit the peak input power consumption as seen by the power supply (e.g., battery supply). Such limiting may be performed by monitoring the operation state of the system in order to continually calculate the maximum allowable inductor current limit of a peak current controlled boost converter for purposes of: (1) protection against maximum supply consumption overloading which can produce a "brownout" condition on a portable device, (2) adjusting the boost converter's maximum allowable input power consumption for changes in the power supply capabilities so that maximum power can be delivered at higher battery charge states without adding risk at lower charge states, and/or (3) creating a "battery saving" mode which scales back power consumption in order to extend battery life under a low charge situation.

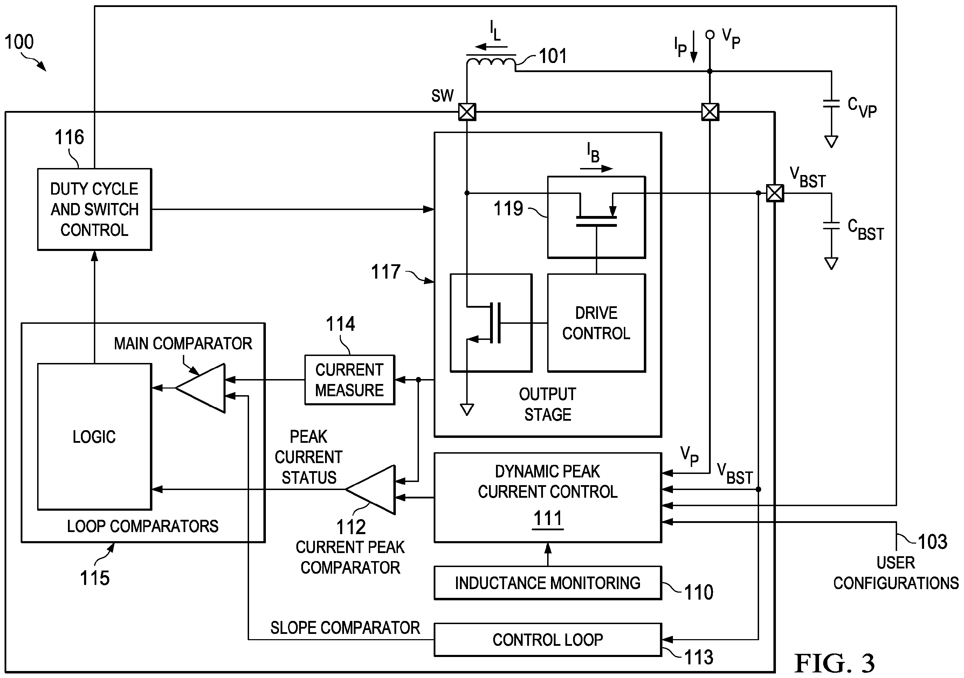

Continually monitoring the state of the power supply allows the system to automatically update the peak inductor current limit in order to take into account changes in the battery's power delivery capabilities. This continual updating allows a boost converter system, such as depicted in FIGURE 3, to take advantage of the additional power delivery when available and scale back allowable consumption when the battery is in a weakened state.

From a user's standpoint, the dynamic peak current control is configured relative to the power supply restrictions desired for the end device. As used herein, the term "user" may broadly include not only an end user of a device including the dynamic peak current control, but also the designer, manufacturer, vendor, or other provider of the device who thus, in a sense, "uses" the dynamic peak current control and the boost converter system including dynamic peak current control in order to build the device. The dynamic peak current control may automatically monitor and/or manage appropriate variables in order not to violate the applicable supply power consumption limitations for the particular application via peak inductor current control. The exact responses and bounds to dynamic changes in the peak current limiting are intended to be user configurable and flexible for various applications.

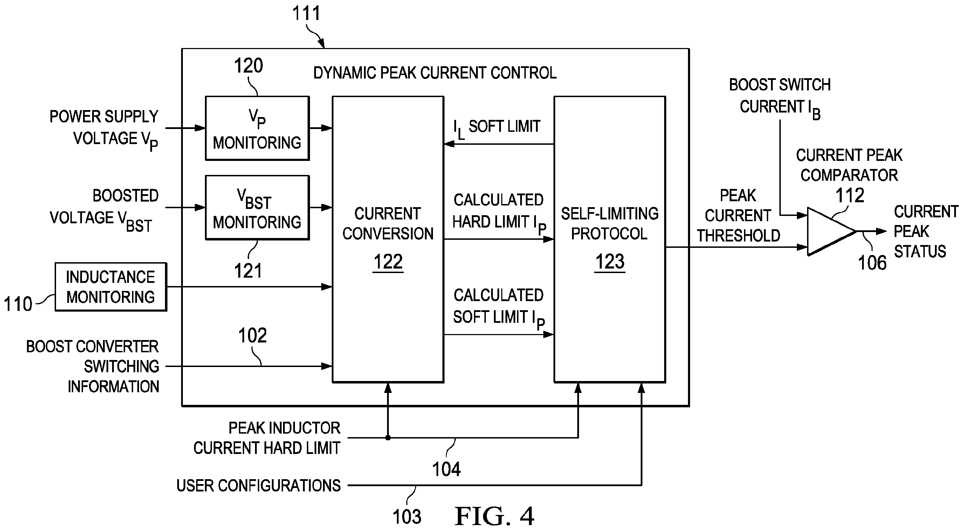

FIGURE 3 illustrates a block diagram of an example boost converter 100, in accordance with embodiments of the present disclosure. FIGURE 4 illustrates a block diagram of an example dynamic peak current control 111 for use in boost converter 100, in accordance with embodiments of the present disclosure. As shown in FIGURE 3 and FIGURE 4, dynamic peak current control 111 may monitor power supply voltage V_{P} (e.g., with V_{P} monitoring 120, the operation of which is described in greater detail below) and boosted supply voltage V_{BST} (e.g., with V_{BST} monitoring 121, the operation of which is described in greater detail below), and may receive an inductance value I_{L} from an inductance monitoring block 110 indicative of an inductance of inductor 101 of power converter 100. Such information may be received via digital or analog signals. Dynamic peak current control 111 may also receive boost converter switching information 102 which may include (but is not limited to) a switching frequency of power converter 100, a duty cycle of switches (e.g., within an output stage 117 of power converter 100) of power converter 100, the operational state of any edge (e.g., electromagnetic interference) control for such switches, a power efficiency of boost converter 100, and/or changes in impedance(s) of such switches that could impact a conversion of a peak inductor current I_{LPEAK} to a power converter input current I_{P}. Such information may be provided to a current conversion block 122 in order to calculate an equivalent average power converter input current I_{P} from a peak inductor current I_{LPEAK}. Such average power converter input current Ip may then be supplied to a soft-limiting control 123, which may serve as a dynamic peak current control state machine.

Soft-limiting control 123 may compare the calculated average power converter input current Ip with user configurations 103 in order to determine if a soft-limiting response is required. A peak inductor current soft limit may dynamically change as appropriate, but may always be of a lesser value than a static peak inductor current hard limit. If a soft-limiting response is required, the soft-limiting control 123 may calculate the necessary soft-limit in order to maintain desired operational conditions relative to the power supply, as set within user configurations 103 or other pre-defined configurations.

If no response is required, soft-limiting control 123 may pass a peak inductor current hard limit 104 to a peak current comparator 112 as a peak current threshold.

When triggered, peak current comparator 112 may communicate an appropriate signal to loop comparators 115, which may in turn signal a duty cycle and switch control 116 that boost switch 119 in output stage 117 must be deactivated (e.g., disabled, opened, turned off, etc.). Such boost switch deactivation may override normal boost converter regulation of a control loop 113. Once boost switch 119 is deactivated, inductor current I_{L} may be begin to decrease, limiting both peak inductor current I_{LPEAK} and power converter input current I_{P}.

V_{P} monitoring block 120 may report supply voltage V_{P} measured via a dedicated sense pin local to a boosted amplifier device comprising boost converter 100, or in any other suitable manner in order to determine a voltage V_{P} at or near an input of inductor 101. Power supply (e.g., battery) voltages may vary from platform to platform, across loading conditions, and across battery charge. Other subsystems of a device comprising boost converter 100 that share a power supply supplying supply voltage V_{P} may also apply dynamic loading to the power supply. In addition, power supplies may have output impedances, and such dynamic loading may cause a raw supply voltage V_{P} to continually change.

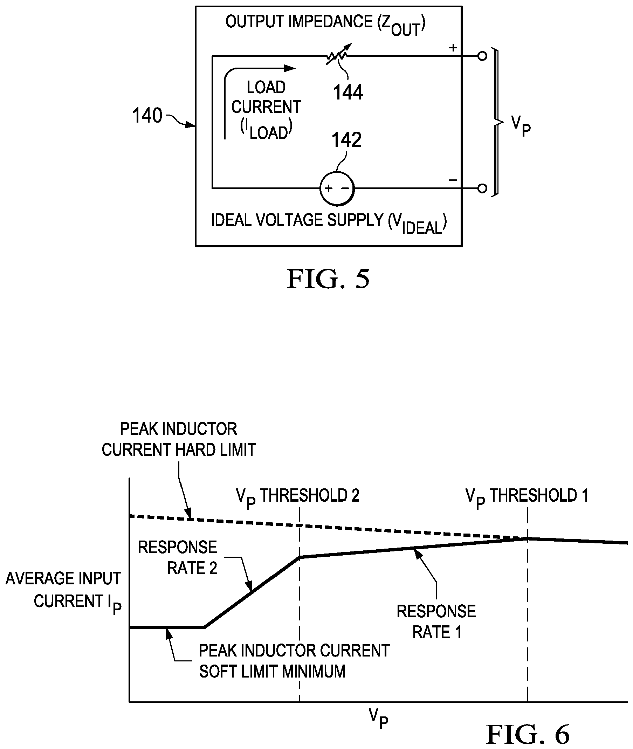

To illustrate, FIGURE 5 is a circuit diagram of a model 140 of an example battery which may be used as a power supply, in accordance with embodiments of the present disclosure. As shown in FIGURE 5, a battery may be modeled as having an ideal voltage supply 142 outputting a voltage V_{IDEAL} and an output impedance 144 with a variable impedance Z_{OUT} which may vary due to change in the level of battery charge, discharge current, aging of the battery, and/or environmental effects. In operation, variable impedance Z_{OUT} may vary due to change in level of battery charge. Thus, as current I_{LOAD} delivered from a battery increases, the output voltage V_{P} it generates may decrease. For example, if one assumes that a particular battery's output impedance (Z_{OUT}) is fixed at 0.3 Ω, and it is not providing any current to a load (e.g., I_{LOAD} = 0 A), and its ideal battery voltage V_{IDEAL} is 3.6 V, then the battery's output voltage V_{P} is equivalent to the ideal battery voltage (V_{P} = V_{IDEAL} = 3.6 V). However, if the battery is providing 1 A of current I_{LOAD} to a load, then output voltage V_{P} = (3.6 V) - (1 A) x (0.3 Ω) = 3.3 V. For a real (non-ideal) battery, V_{P} may often be less than 3.3V.

As the supply voltage V_{P} may continually change in both a slow, almost direct-current (DC)-like manner, and in a faster transient manner, in order to accurately convert peak inductor current I_{LPEAK} to input supply current I_{P}, supply voltage V_{P} must be continually monitored. From a state machine response standpoint of soft-limiting control 123, supply voltage V_{P} may be compared against one or more thresholds in order to trigger a state machine response, or initiate the peak inductor current limiting to directly track supply voltage V_{P} for purposes of adjusting the soft-limiting.

V_{BST} Monitoring 121 may report boosted voltage V_{BST} from boost converter 100. Depending on the architecture of boost converter 100, boosted voltage V_{BST} may change based on regulation capabilities of boost converter 100. For example, in some boost converter architectures, poor alternating-current (AC) regulation may be acceptable. Others might track loading signal requirements, such as a Class-H boosted amplifier architecture. A boost converter may also enter a condition in which loss of regulation occurs under heavy load once a peak inductor current limit has been reached. Such condition may rapidly change boost voltage V_{BST}.

Inductance monitoring 110 may track an inductance of inductor 101. An actual inductance value may vary from part-to-part, vary across temperature, and/or vary under different heavy loading conditions. For example, actual inductances may vary by as much as 30% relative to a typical specified nominal inductance value. The actual inductance may have a dominant effect on a slope of a ripple current through inductor 101 and the ability to convert peak inductor current I_{LPEAK} to supply current I_{P}. In order to minimize errors in converting peak inductor current I_{LPEAK} to supply current Ip, the actual inductance of inductor 101 must be monitored to account for any variations and real time changes.

Current conversion block 122 may correlate a peak inductor current I_{LPEAK} over to supply current I_{P} for purposes of limiting supply power consumption by boost converter 100. Current conversion may be performed for both the soft limit from the soft-limiting control 123 and peak inductor current hard limit 104. Both the calculated hard limit and soft limit (relative to supply current I_{P}) may be provided to soft-limiting control 123.

For purposes of power management, supply current I_{P} may be the reference current of most concern for leveraging a peak inductor current soft-limiting power management scheme. It is often supply current I_{P} consumption, not the ripple of current inductor current I_{L}, which determines whether a portable device will "brownout."

Peak inductor current hard limit 104 may comprise a static limit which is configured by a user. Peak inductor current hard limit 104 may typically be set based on the current handling capabilities of inductor 101. Peak inductor current hard limit 104 may be configured to be the maximum peak inductor current I_{LPEAK} which may be allowed during any point of operation.

Peak current comparator 112 may compare a boost switch current I_{B} through boost switch 119 (which should be identical to inductor current I_{L} when boost switch 119 is activated) with a pre-configured hard or soft limit, and when boost switch current I_{B} exceeds the pre-configured (hard or soft) limit, the peak current comparator 112 may generate a signal to deactivate boost switch 119. Deactivating boost switch 119 once boost switch current I_{B}/inductor current I_{L} has reached the peak current threshold may limit peak inductor current I_{LPEAK} through inductor 101, and by extension, power consumption of boost converter 100 from the power supply.

The peak current threshold which is communicated to peak current comparator 112 may be based on either the static peak inductor current hard limit, or the dynamic peak inductor current soft limit. In some embodiments, the peak inductor current soft limit cannot exceed the hard limit set by the system. Typically, when the soft limit engages, it starts off with a threshold slightly less than the hard limit. When soft-limiting is no longer necessary, the threshold of peak current comparator 112 may return to the hard limit value.

User configurations 103 may allow a user to customize a response of dynamic peak current control 111 based on system level requirements. Such user configurations 103 may include, but are not limited to, a voltage response threshold(s), a number of voltage response thresholds, slope responses of each threshold, state machine response timings, ΔI_{P}/ΔV_{P} relationships (e.g., how the soft current limit is controlled relative to the change in supply voltage V_{P}), a desired amount or limit on the amount of peak current limiting, and options for recovery once supply voltage V_{P} has recovered.

As shown in FIGURE 4, soft-limiting control 123 may receive user configurations 103, peak inductor current hard limit 104, and calculated hard limit input current I_{P} and soft limit input current I_{P} from the current conversion 122. From such information, soft-limiting control 123 may determine if peak inductor current I_{LPEAK} needs to be reduced below the static hard limit to manage power consumption from the power supply of boost converter 100. If so, a peak inductor current soft limit may be calculated and output to peak current comparator 112, thereby reducing the maximum amount of inductor current I_{L} allowed through boost switch 119. A single peak current limit threshold may be output from soft-limiting control 123 (within dynamic peak current control 111) to peak current comparator 112. Either the peak inductor current dynamic soft limit or static hard limit may be active at a given time. Accordingly, soft-limiting control 123 may manage the limiting to peak current comparator 112, thus allowing the use of a single peak current comparator 112 to be utilized for both hard-limiting and soft-limiting.

At least two different methods may be used to control input current I_{P} through manipulation of peak inductor current limiting. A first method, referred to herein as "Method 1," may allow for a more gradual response and more immediate recovery. Method 1 may be used as both a transient response system and a battery saver system wherein reduction of input current I_{P} is adjusted as a continual direct response to the changes in supply voltage V_{P}. A second method, referred to herein as "Method 2," may typically have a more immediate and aggressive response than that of Method 1 once it is triggered. Method 2 may be more specific to handling transient loading conditions and rapidly restricting input power consumption of boost converter 100 so that the power supply has a chance to recover and prevent from browning out a system comprising boost converter 100.

Based on a desired power management response, Method 1 and Method 2 can be used in conjunction with each other or in isolation. For example, in a portable, battery powered device where a battery can both slowly discharge, producing a reduction in supply voltage V_{P}, and where bursts of transient loading conditions can cause fast drops in supply voltage V_{P}, both of Method 1 and 2 may be desirable for use at the same time.

### Method 1

Method 1 may track supply voltage V_{P} and scale the maximum allowable current I_{P} consumption along with supply voltage V_{P}. Method 1 may allow for single or multiple thresholds, with configurable response rates for change in maximum allowable current V_{P} consumption with respect to changes in supply voltage V_{P} (e.g., ΔI_{P}/ΔV_{P}) which can either be updated in real-time or in a delayed manner in order to prevent potential control loop oscillations. Such approach may allow dynamic peak current control 111 to increase or decrease the allowable peak input current I_{P} consumption in order to scale supply voltage V_{P} consumption based on power supply (e.g., battery) capabilities.

Single or multiple thresholds may allow for a gradual initial phase of current limiting when the risk of overloading or browning out the system is low. A more aggressive response can be applied when the battery is in a weakened state and the system is in a state more vulnerable to overload or a system wide brownout. For example, FIGURE 6 depicts a graph of average input current V_{P} versus supply voltage V_{P} to illustrate an example of how a multi-threshold approach with programmable response rates could respond with a varying supply voltage V_{P}, in accordance with embodiments of the present disclosure. This example assumes other variables, such as inductance of inductor 101, boosted voltage V_{BST}, and a load of the power supply, remain constant. As shown in FIGURE 6, an absolute minimum may also be applied to the inductor current soft-limiting performed by soft-limiting control 123. Once this absolute minimum value has been reached, a response rate relationship (e.g., Response Rate 2 shown in FIGURE 6) between supply voltage V_{P} and the current limiting may become further limited by the configured soft-limiting minimum.

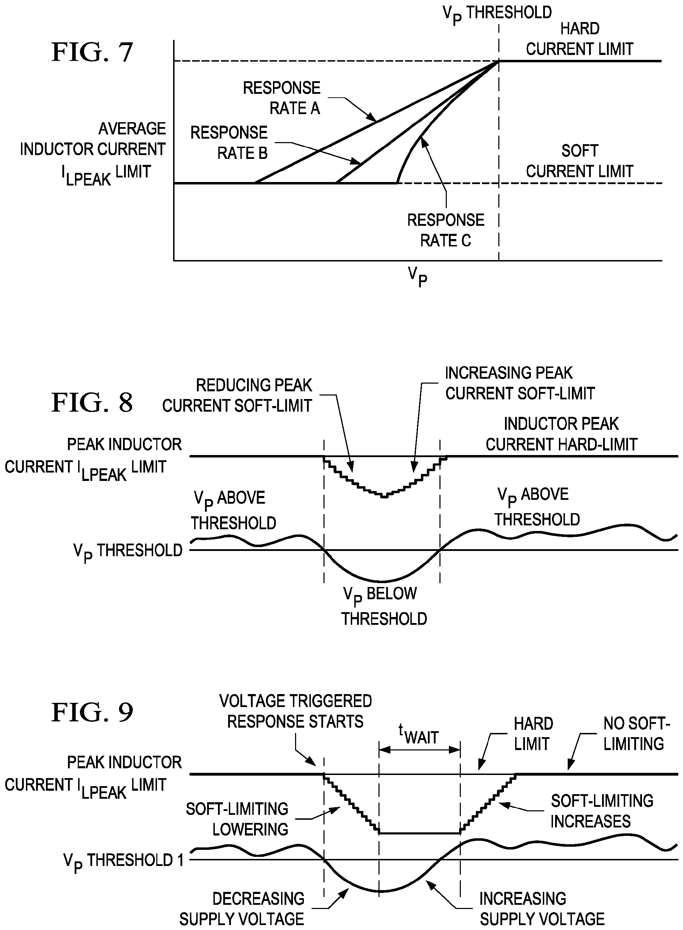

FIGURE 7 depicts a graph of peak inductor current I_{LPEAK} limit versus supply voltage V_{P} to illustrate how a user may configure various response rates in order to customize the soft-limiting response based on system power to a system comprising boost converter 100 and how it might correspond to limiting of the peak inductor current, in accordance with embodiments of the present disclosure. The peak inductor current limit response rates may be linear or non-linear based on a combination of the user's configuration when tracking the response to the drop in supply voltage V_{P} and changes to the inductor current I_{L} and input current V_{P} relationship.

FIGURE 8 depicts a graph of peak inductor current I_{LPEAK} limit and supply voltage V_{P} over time to illustrate how a single-threshold linear response could track a supply voltage V_{P} transient waveform in order to reduce input current consumption as supply voltage V_{P} decreases in order to prevent a system comprising boost converter 100 from browning out due to pulling more current from the power supply than the power supply is able to provide, in accordance with embodiments of the present disclosure. Prior to supply voltage V_{P} decreasing below a V_{P} threshold, the peak inductor current limit may reside at a peak inductor current hard-limit. After supply voltage V_{P} decreases back above the V_{P} threshold again and the soft-limiting has had a chance to catch up to the change in supply voltage V_{P}, peak inductor current I_{LPEAK} may return to the hard-limit in order to allow for maximum power delivery for boost converter 100.

### Method 2

Method 2 may comprise a triggered time-based system in which a combination of timers, user configurable response step sizes, and threshold(s) may be utilized to determine a response. Instead of tracking supply voltage V_{P} directly with a ΔI_{P}/ΔV_{P} approach once a threshold supply voltage V_{P} has been violated, Method 2 may employ an attacking state in which a peak inductor current soft-limit is reduced at a configurable rate in response to a voltage transient in supply voltage V_{P}. Thus, Method 2 is intended to prevent a large amount of current to be consumed which may otherwise risk an overload or a brownout condition.

Method 2 may be designed to intentionally overreact from a soft-limiting standpoint in order to reduce input current I_{P} consumption as quickly as possible and allow for a fast recovery for supply voltage V_{P}. As discussed in the Background section, a distributed capacitance may appear at the output of the power supply. Such capacitance may take some time to recharge after a heavy loading event has occurred. Thus, reducing the allowable power consumption of boost converter 100 in a quick and aggressive manner may allow supply voltage V_{P} to more quickly recover and may reduce the potential of a brownout event on the end device.

FIGURE 9 depicts a graph of peak inductor current I_{LPEAK} limit and supply voltage V_{P} over time to illustrate an example implementation of a peak inductor current limiting time-based response, in accordance with embodiments of the present disclosure. As shown in FIGURE 9, when supply voltage V_{P} falls below a first threshold V_{P} Threshold 1, peak current soft-limiting may be triggered and soft-limiting control 123 may begin to reduce the limit of peak inductor current I_{LPEAK}. As long as supply voltage V_{P} remains below VP Threshold 1 and continues to decrease, the limit of peak inductor current I_{LPEAK} may continue to be reduced.

Once supply voltage V_{P} stops decreasing, soft-limiting control 123 may remain static for a configurable period of time t_{WAIT}. Once this period of time has expired, the soft-limiting of soft-limiting control 123 may begin to release, and soft-limiting control 123 may increase the peak inductor current soft limit until it either reaches the hard limit, supply voltage V_{P} remains below V_{P} Threshold 1 and starts to decrease again, or supply voltage V_{P} returns above V_{P} Threshold 1 and then at a later point in time decreases back below V_{P} Threshold 1, at which time soft-limiting control 123 may reduce the maximum allowable peak current again via the dynamic soft limit. Waiting for the supply voltage V_{P} to start increasing allows for an aggressive response when a low supply voltage condition first occurs, but produces a quick recovery of allowable power through boost converter 100 as soon as the supply voltage V_{P} shows signs of recovery in order to minimize the total amount of time in which power delivery to boost converter 100 is impacted.

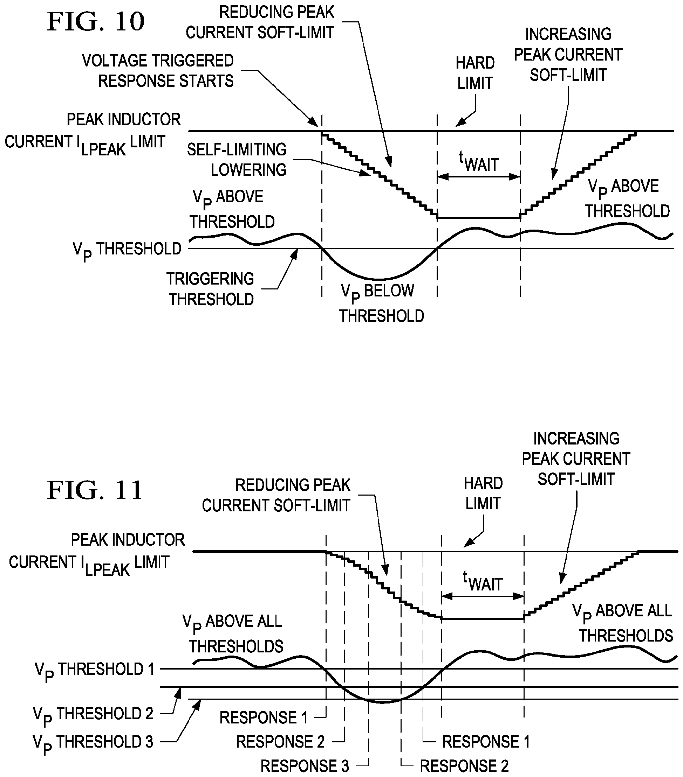

FIGURE 10 depicts a graph of peak inductor current I_{LPEAK} limit and supply voltage V_{P} over time to illustrate an example implementation in which a peak current soft-limit is continually reduced until the supply voltage V_{P} has returned above an initial triggering threshold of a peak inductor current limiting time-based response, in accordance with embodiments of the present disclosure. This continual reduction may rapidly drive down input current V_{P} consumption for an extended period of time in order to allow the supply voltage V_{P} to recover. This example implementation is more heavily weighted towards ensuring recovery of supply voltage V_{P} than minimizing the impact on power delivery to boost converter 100. Due to the longer period of time where the soft limit is actively being reduced, the minimum soft-limit value may be lower and may take longer to return to normal operation than the example implementation of FIGURE 9.

FIGURE 11 depicts a graph of peak inductor current I_{LPEAK} limit and supply voltage V_{P} over time to illustrate an example implementation utilizing a multi-threshold response wherein as supply voltage V_{P} decreases below each threshold, a different response rate is applied for each threshold, in accordance with embodiments of the present disclosure. A plurality of thresholds (e.g., V_{P} Threshold 1, V_{P} Threshold 2, and V_{P} Threshold 3) may correspond to different user configurable levels such that when supply voltage V_{P} decreases below each such threshold, a different response (e.g., Response 1, Response 2, Response 3) is triggered. For purposes of this example, Response 1, Response 2, and Response 3 may comprise different step reductions with a fixed time rate. Such response steps may become progressively more aggressive as the peak current limiting progresses from Response 1 to Response 3. Such multi-threshold response may be performed to minimize the reduction of peak inductor current soft-limiting for smaller decreases in supply voltage V_{P}, while automatically scaling up the response step sizes to respond when a larger decrease occurs in supply voltage V_{P}. In a time based soft-limiting approach, the implementation of FIGURE 11 may have the benefit of reducing overreactions for small, transient decreases of supply voltage V_{P}, while still allowing a large power restriction for more severe decreases of supply voltage V_{P}.

This disclosure encompasses all changes, substitutions, variations, alterations, and modifications to the exemplary embodiments herein that a person having ordinary skill in the art would comprehend. Similarly, where appropriate, the appended claims encompass all changes, substitutions, variations, alterations, and modifications to the exemplary embodiments herein that a person having ordinary skill in the art would comprehend. Moreover, reference in the appended claims to an apparatus or system or a component of an apparatus or system being adapted to, arranged to, capable of, configured to, enabled to, operable to, or operative to perform a particular function encompasses that apparatus, system, or component, whether or not it or that particular function is activated, turned on, or unlocked, as long as that apparatus, system, or component is so adapted, arranged, capable, configured, enabled, operable, or operative.

All examples and conditional language recited herein are intended for pedagogical objects to aid the reader in understanding the disclosure and the concepts contributed by the inventor to furthering the art, and are construed as being without limitation to such specifically recited examples and conditions. Although embodiments of the present disclosure have been described in detail, it should be understood that various changes, substitutions, and alterations could be made hereto without departing from the scope of the disclosure as defined by the claims.

## Claims

1. A method for an apparatus comprising a boost converter having a power supply input for receiving an input power supply voltage of a power supply, an inductor, and an output for generating an output voltage greater than the input power supply voltage, the method comprising:
monitoring the input power supply voltage of the power supply;
monitoring an inductance of the inductor (101) of the boost converter (100) comprising the inductor;
monitoring one or more other characteristics of the boost converter; and
calculating a target peak inductor current based on the input power supply voltage, the inductance, the one or more other characteristics of the boost converter, and a target average current of the inductor during a switching cycle of the boost converter.

2. The method of Claim 1, further comprising controlling an average current of the inductor by regulating a peak inductor current of the inductor in accordance with a maximum average inductor current during a switching cycle.

3. The method of Claim 1, wherein the one or more characteristics comprise at least one of: a duty cycle for switching of a switch of the boost converter; an output voltage of the boost converter; an output current of the boost converter; and an efficiency of the boost converter.

4. The method of Claim 1, further comprising deactivating a switch (119) of the boost converter in response to an instantaneous inductor current of the inductor exceeding the target peak inductor current.

5. The method of Claim 1, further comprising controlling an instantaneous inductor current and the target peak inductor current based on a user configuration.

6. The method of Claim 5, wherein the user configuration comprises at least one of a voltage response threshold, a slope response of a voltage response threshold, state machine response timings, changes of supply current with respect to input power supply voltage, a desired limit of the target peak inductor current, and recovery options in response to recovery of the power supply.

7. An apparatus comprising:
a boost converter (100) having a power supply input for receiving an input power supply voltage of a power supply, an inductor (101), and an output for generating an output voltage greater than the input power supply voltage; and
a controller (111) configured to:
monitor the input power supply voltage;
monitor the inductance of the inductor;
monitor one or more other characteristics of the boost converter; and
calculate a target peak inductor current based on the input power supply voltage, the inductance, the one or more other characteristics of the boost converter, and a target average current of the inductor during a switching cycle of the boost converter.

8. The apparatus of Claim 7, wherein the controller (111) is further configured to control an average current of the inductor by regulating a peak inductor current of the inductor in accordance with a maximum average inductor current during a switching cycle.

9. The apparatus of Claim 7, wherein the one or more characteristics comprise at least one of: a duty cycle for switching of a switch of the boost converter; an output voltage of the boost converter; an output current of the boost converter; and an efficiency of the boost converter.

10. The apparatus of Claim 7, wherein the controller is further configured to deactivate a switch (119) of the boost converter in response to an instantaneous inductor current of the inductor exceeding the target peak inductor current.

11. The apparatus of Claim 7, wherein the controller is further configured to control an instantaneous inductor current and the target peak inductor current based on a user configuration.

12. The apparatus of Claim 7, wherein the user configuration comprises at least one of a voltage response threshold, a slope response of a voltage response threshold, state machine response timings, changes of supply current with respect to input power supply voltage, a desired limit of the target peak inductor current, and recovery options in response to recovery of the power supply.

13. The apparatus of Claim 7, wherein the controller is further configured to reduce the target peak inductor current in a controllable manner responsive to the input power supply voltage falling below a threshold voltage.

14. A method for an apparatus comprising a boost converter having a power supply input for receiving an input power supply voltage of a power supply, an inductor, and an output for generating an output voltage greater than the input power supply voltage, the method comprising:
monitoring the input power supply voltage of the power supply;
monitoring an inductance of the inductor of the boost converter comprising the inductor;
monitoring one or more other characteristics of the boost converter; and
calculating an average current of the inductor during a switching cycle of the boost converter based on the input power supply voltage, the inductance, the one or more other characteristics of the boost converter, and a peak inductor current of the inductor.

15. An apparatus comprising:
a boost converter having a power supply input for receiving an input power supply voltage of a power supply, an inductor, and an output for generating an output voltage greater than the input power supply voltage; and
a controller configured to:
monitor the input power supply voltage;
monitor the inductance of the inductor;
monitor one or more other characteristics of the boost converter; and
calculate an average current of the inductor during a switching cycle of the boost converter based on the input power supply voltage, the inductance, the one or more other characteristics of the boost converter, and a peak inductor current of the inductor.

## Patentansprüche

1. Verfahren für eine Vorrichtung umfassend einen Hochsetzsteller mit einem Spannungsversorgungseingang, um von einer Stromquelle eine Eingangsversorgungsspannung zu empfangen, einen Induktor, und einen Ausgang, um eine Ausgangsspannung zu erzeugen, die größer als die Eingangsversorgungsspannung ist, wobei das Verfahren umfasst:
die Eingangsversorgungsspannung der Stromquelle beobachten;
die Induktivität des Induktors (101) des den Induktor umfassenden Hochsetzstellers (100) beobachten;
eine oder mehrere andere Eigenschaften des Hochsetzstellers beobachten; und
einen angestrebten Spitzeninduktorstrom anhand der Eingangsversorgungsspannung, der Induktivität, der einen oder der mehreren anderen Eigenschaften des Hochsetzstellers und eines angestrebten Strommittelwerts des Induktors während eines Hochsetzsteller-Schaltspiels berechnen.

2. Verfahren gemäß Anspruch 1, ferner umfassend einen Strommittelwert des Induktors zu steuern, indem ein angestrebter Spitzeninduktorstrom des Induktors entsprechend einem maximalen Induktorstrommittelwert während eines Schaltspiels geregelt wird.

3. Verfahren gemäß Anspruch 1, wobei die eine oder die mehreren Eigenschaften mindestens eine der folgenden Eigenschaften umfassen: eine Einschaltdauer, um einen Schalter des Hochsetzstellers zu schalten; eine Ausgangsspannung des Hochsetzstellers; einen Ausgangsstrom des Hochsetzstellers; und einen Wirkungsgrad des Hochsetzstellers.

4. Verfahren gemäß Anspruch 1, ferner umfassend einen Schalter (119) des Hochsetzstellers als Reaktion darauf zu deaktivieren, dass ein Augenblicksinduktorstrom den angestrebten Spitzeninduktorstrom übersteigt.

5. Verfahren gemäß Anspruch 1, ferner umfassend einen Augenblicksinduktorstrom und den angestrebten Spitzeninduktorstrom anhand einer Anwenderkonfiguration zu steuern.

6. Verfahren gemäß Anspruch 5, wobei die Anwenderkonfiguration mindestens der folgenden umfasst: eine Spannungsansprechschwelle, eine Slope-Antwort einer Spannungsansprechschwelle, Maschinenzustand-Antwort-Timings, Änderungen im Versorgungsstrom in Bezug auf die Eingangsversorgungsspannung, eine gewünschte Grenze des angestrebten Spitzeninduktorstroms und Wiederherstellungsoptionen als Reaktion auf die Wiederherstellung der Stromversorgung.

7. Vorrichtung, umfassend:
einen Hochsetzsteller (100) mit einem Spannungsversorgungseingang, um von einer Stromquelle eine Eingangsversorgungsspannung zu empfangen, einen Induktor (101), und einen Ausgang, um eine Ausgangsspannung zu erzeugen, die größer als die Eingangsversorgungsspannung ist; und
eine Steuereinheit (111), die dafür ausgelegt ist:
die Eingangsversorgungsspannung zu beobachten;
die Induktivität des Induktors zu beobachten;
eine oder mehrere andere Eigenschaften des Hochsetzstellers zu beobachten; und
einen angestrebten Spitzeninduktorstrom anhand der Eingangsversorgungsspannung, der Induktivität, der einen oder der mehreren anderen Eigenschaften des Hochsetzstellers, eines angestrebten Strommittelwerts des Induktors während eines Hochsetzsteller-Schaltspiels zu berechnen.

8. Vorrichtung gemäß Anspruch 7, wobei die Steuereinheit (111) ferner dafür ausgelegt ist, einen Strommittelwert des Induktors zu steuern, indem ein angestrebter Spitzeninduktorstrom des Induktors entsprechend einem maximalen Induktorstrommittelwert während eines Schaltspiels geregelt wird.

9. Vorrichtung gemäß Anspruch 7, wobei die eine oder die mehreren Eigenschaften mindestens eine der folgenden Eigenschaften umfassen: eine Einschaltdauer, um einen Schalter des Hochsetzstellers zu schalten; eine Ausgangsspannung des Hochsetzstellers; einen Ausgangsstrom des Hochsetzstellers; und einen Wirkungsgrad des Hochsetzstellers.

10. Vorrichtung gemäß Anspruch 7, wobei die Steuereinheit ferner dafür ausgelegt ist, einen Schalter (119) des Hochsetzstellers als Reaktion darauf zu deaktivieren, dass ein Augenblicksinduktorstrom den angestrebten Spitzeninduktorstrom übersteigt.

11. Vorrichtung gemäß Anspruch 7, wobei die Steuereinheit ferner dafür ausgelegt ist, einen Augenblicksinduktorstrom und den angestrebten Spitzeninduktorstrom anhand einer Anwenderkonfiguration zu steuern.

12. Vorrichtung gemäß Anspruch 7, wobei die Anwenderkonfiguration mindestens eines der folgenden umfasst: eine Spannungsansprechschwelle, eine Slope-Antwort einer Spannungsansprechschwelle, Maschinenzustand-Antwort-Timings, Änderungen im Versorgungsstrom in Bezug auf die Eingangsversorgungsspannung, eine gewünschte Grenze des angestrebten Spitzeninduktorstroms und Wiederherstellungsoptionen als Reaktion auf die Wiederherstellung der Stromversorgung.

13. Vorrichtung gemäß Anspruch 7, wobei die Steuereinheit ferner dafür ausgelegt ist, den angestrebten Spitzeninduktorstrom auf eine steuerbare Weise als Reaktion darauf zu reduzieren, dass die Eingangsversorgungsspannung unter eine Schwellenspannung fällt.

14. Verfahren für eine Vorrichtung umfassend einen Hochsetzsteller mit einem Spannungsversorgungseingang, um von einer Stromquelle eine Eingangsversorgungsspannung zu empfangen, einen Induktor, und einen Ausgang, um eine Ausgangsspannung zu erzeugen, die größer als die Eingangsversorgungsspannung ist, wobei das Verfahren umfasst:
die Eingangsversorgungsspannung der Stromquelle beobachten;
die Induktivität des Induktors des den Induktor umfassenden Hochsetzstellers beobachten;
eine oder mehrere andere Eigenschaften des Hochsetzstellers beobachten; und
einen Strommittelwert des Induktors während eines Hochsetzsteller-Schaltspiels anhand der Eingangsversorgungsspannung, der Induktivität, der einen oder der mehreren anderen Eigenschaften des Hochsetzstellers und eines Spitzeninduktorstroms des Induktors berechnen.

15. Vorrichtung, umfassend:
einen Hochsetzsteller mit einem Spannungsversorgungseingang, um von einer Stromquelle eine Eingangsversorgungsspannung zu empfangen und einen Ausgang, um eine Ausgangsspannung zu erzeugen, die größer als die Eingangsversorgungsspannung ist; und
eine Steuereinheit, die dafür ausgelegt ist:
die Eingangsversorgungsspannung zu beobachten;
die Induktivität des Induktors zu beobachten;
eine oder mehrere andere Eigenschaften des Hochsetzstellers zu beobachten; und
einen Strommittelwert der Induktorspule während eines Hochsetzsteller-Schaltspiels anhand der Eingangsversorgungsspannung, der Induktivität, der einen oder der mehreren anderen Eigenschaften des Hochsetzstellers und eines Spitzeninduktorstroms des Induktors zu berechnen.

## Revendications

1. Un procédé pour un appareil comprenant un convertisseur élévateur ayant une entrée d'alimentation électrique pour recevoir une tension d'alimentation électrique d'entrée d'une alimentation électrique, un inducteur, et une sortie pour générer une tension de sortie supérieure à la tension d'alimentation électrique d'entrée, le procédé comprenant :
la surveillance de la tension d'alimentation électrique d'entrée de l'alimentation électrique ;
la surveillance d'une inductance de l'inducteur (101) du convertisseur élévateur (100) comprenant l'inducteur ;
la surveillance d'une ou plusieurs autres caractéristiques du convertisseur élévateur ; et
le calcul d'un courant inducteur de pic cible sur la base de la tension d'alimentation électrique d'entrée, de l'inductance, d'une ou plusieurs autres caractéristiques du convertisseur élévateur, et d'un courant moyen cible de l'inducteur pendant un cycle de commutation du convertisseur élévateur.

2. Le procédé selon la revendication 1, comprenant en outre le contrôle d'un courant moyen de l'inducteur par la régulation d'un courant inducteur de pic de l'inducteur en fonction d'un courant inducteur moyen maximum pendant un cycle de commutation.

3. Le procédé selon la revendication 1, dans lequel l'une ou les plusieurs caractéristiques comprennent au moins un de : un rapport cyclique pour la commutation d'un commutateur du convertisseur élévateur ; une tension de sortie du convertisseur élévateur ; un courant de sortie du convertisseur élévateur ; et une efficacité du convertisseur élévateur.

4. Le procédé selon la revendication 1, comprenant en outre la désactivation d'un commutateur (119) du convertisseur élévateur en réponse à un courant inducteur instantané de l'inducteur dépassant le courant inducteur de pic cible.

5. Le procédé selon la revendication 1, comprenant en outre le contrôle d'un courant inducteur instantané et du courant inducteur de pic cible sur la base d'une configuration utilisateur.

6. Le procédé selon la revendication 5, dans lequel la configuration utilisateur comprend au moins un d'un seuil de réponse de tension, une réponse de pente d'un seuil de réponse de tension, des temporisations de réponse de machine d'état, des changements de courant d'alimentation par rapport à la tension d'alimentation électrique d'entrée, une limite souhaitée du courant inducteur de pic cible, et des options de récupération en réponse à la récupération de l'alimentation électrique.

7. Un appareil comprenant :
un convertisseur élévateur (100) ayant une entrée d'alimentation électrique pour recevoir une tension d'alimentation électrique d'entrée d'une alimentation électrique, un inducteur (101), et une sortie pour générer une tension de sortie supérieure à la tension d'alimentation électrique d'entrée ; et
un contrôleur (111) configuré pour :
surveiller la tension d'alimentation électrique d'entrée ;
surveiller l'inductance de l'inducteur ;
surveiller une ou plusieurs autres caractéristiques du convertisseur élévateur ; et
calculer un courant inducteur de pic cible sur la base de la tension d'alimentation électrique d'entrée, de l'inductance, de l'une ou des plusieurs autres caractéristiques du convertisseur élévateur, et d'un courant moyen cible de l'inducteur pendant un cycle de commutation du convertisseur élévateur.

8. L'appareil selon la revendication 7, dans lequel le contrôleur (111) est en outre configuré pour contrôler un courant moyen de l'inducteur en régulant un courant inducteur de pic de l'inducteur en fonction d'un courant inducteur moyen maximum pendant un cycle de commutation.

9. L'appareil selon la revendication 7, dans lequel l'une ou les plusieurs caractéristiques comprennent au moins un de ; un rapport cyclique pour la commutation d'un commutateur du convertisseur élévateur ; une tension de sortie du convertisseur élévateur ; un courant de sortie du convertisseur élévateur ; et une efficacité du convertisseur élévateur.

10. L'appareil selon la revendication 7, dans lequel le contrôleur est en outre configuré pour désactiver un commutateur (119) du convertisseur élévateur en réponse à un courant inducteur instantané de l'inducteur dépassant le courant inducteur de pic cible.

11. L'appareil selon la revendication 7, dans lequel le contrôleur est en outre configuré pour contrôler un courant inducteur instantané et le courant inducteur de pic cible sur la base d'une configuration utilisateur.

12. L'appareil selon la revendication 7, dans lequel la configuration utilisateur comprend au moins un d'un seuil de réponse de tension, une réponse de pente d'un seuil de réponse de tension, des temporisations de réponse de machine d'état, des changements de courant d'alimentation par rapport à la tension d'alimentation électrique d'entrée, une limite souhaitée du courant inducteur de pic cible, et des options de récupération en réponse à la récupération de l'alimentation électrique.

13. L'appareil selon la revendication 7, dans lequel le contrôleur est en outre configuré pour réduire le courant inducteur de pic cible d'une manière contrôlable en réponse à la tension d'alimentation électrique d'entrée tombant en dessous d'une tension de seuil.

14. Un procédé pour un appareil comprenant un convertisseur élévateur ayant une entrée d'alimentation électrique pour recevoir une tension d'alimentation électrique d'entrée d'une alimentation électrique, un inducteur, et une sortie pour générer une tension de sortie supérieure à la tension d'alimentation électrique d'entrée, le procédé comprenant :
la surveillance de la tension d'alimentation électrique d'entrée de l'alimentation électrique ;
la surveillance d'une inductance de l'inducteur du convertisseur élévateur comprenant l'inducteur ;
la surveillance d'une ou plusieurs autres caractéristiques du convertisseur élévateur ; et
le calcul d'un courant moyen de l'inducteur pendant un cycle de commutation du convertisseur élévateur sur la base de la tension d'alimentation électrique d'entrée, de l'inductance, de l'une ou des plusieurs autres caractéristiques du convertisseur élévateur, et d'un courant inducteur de pic de l'inducteur.

15. Un appareil comprenant :
un convertisseur élévateur ayant une entrée d'alimentation électrique pour recevoir une tension d'alimentation électrique d'entrée d'une alimentation électrique, un inducteur, et une sortie pour générer une tension de sortie supérieure à la tension d'alimentation électrique d'entrée ; et
un contrôleur configuré pour :
surveiller la tension d'alimentation électrique d'entrée ;
surveiller l'inductance de l'inducteur ;
surveiller une ou plusieurs autres caractéristiques du convertisseur élévateur ; et
calculer un courant moyen de l'inducteur pendant un cycle de commutation du convertisseur élévateur sur la base de la tension d'alimentation électrique d'entrée, de l'inductance, de l'une ou des plusieurs autres caractéristiques du convertisseur élévateur, et d'un courant inducteur de pic de l'inducteur.
